# EUROPÄISCHE PATENTANMELDUNG

(11) **EP 4 040 510 A1**
(43) Veröffentlichungstag der Anmeldung: **10.08.2022**
(21) Anmeldenummer: 22000022.8
(22) Anmeldetag: 01.02.2022
(51) Int. Cl.: H01L 31/18

(54) **VERFAHREN ZUR STRUKTURIERUNG EINER ISOLATIONSSCHICHT AUF EINER HALBLEITERSCHEIBE**

(30) Priorität: 09.02.2021 DE 102021000640
(71) Anmelder: AZUR SPACE Solar Power GmbH, 74072 Heilbronn (DE)
(72) Erfinder: Frey, Alexander, 74223 Flein (DE); Hagedorn, Benjamin, 74189 Weinsberg (DE)
(74) Vertreter: Koch Müller Patentanwaltsgesellschaft mbH

(57) **Zusammenfassung**

Verfahren zur Strukturierung einer Isolationsschicht auf einer Halbleiterscheibe, mindestens umfassend die Schritte: Bereitstellen einer Halbleiterscheibe mit einer Oberseite, einer Unterseite und umfassend mehrere Solarzellenstapel, wobei jeder Solarzellenstapel ein die Unterseite der Halbleiterscheibe ausbildendes Ge-Substrat, eine Ge-Teilzelle und mindestens zwei III-V-Teilzellen in der genannten Reihenfolge sowie mindestens eine von der Oberseite bis zu der Unterseite der Halbleiterscheibe reichende Durchgangsöffnung mit zusammenhängender Seitenwand, flächig aufgebrachte Isolationsschicht auf der Oberseite der Halbleiterscheibe, der Seitenwand der Durchgangsöffnung und/oder der Unterseite der Halbleiterscheibe und Aufbringen eines ätzresistenten Füllmaterials mittels eines Druckverfahrens auf einen die Durchgangsöffnung umfassenden Bereich der Oberseite und in die Durchgangsöffnung hinein.

## Beschreibung

Die Erfindung betrifft ein Verfahren zur Strukturierung einer Isolationsschicht auf einer Halbleiterscheibe.

Um die Abschattung der Vorderseite einer Solarzelle zu reduzieren, ist es möglich, sowohl die positive als auch die negative externe Kontaktfläche auf der Rückseite anzuordnen. Bei sogenannten Metal-Wrap-Through (MWT) - Solarzellen wird der Vorderseitenkontakt der Solarzelle beispielsweise durch eine Durchgangskontaktöffnung auf die Rückseite der Solarzelle geführt und dort kontaktiert.

Es sind unterschiedliche Verfahren zur Herstellung eines Lochs bzw. einer Durchgangskontaktöffnung durch eine Solarzelle bekannt. Die durch die Durchgangsöffnung verlaufende Metallisierung wird mittels eines dielektrischen Schichtsystems gegenüber den Schichten des Solarzellenstapels elektrisch isoliert. Das dielektrische Schichtsystem umfasst wenigstens eine Isolationsschicht.

Beispielsweise ist aus der US 9,680,035 B1 ein Solarzellenstapel aus mehreren III-V-Teilzellen auf einem GaAs-Substrat mit rückseitenkontaktierter Vorderseite bekannt, wobei ein von der Oberseite der Solarzelle durch die Teilzellen bis in eine noch nicht gedünnte Substratschicht hineinreichendes Loch mittels eines nasschemischen Ätzprozesses erzeugt wird. Der Ätzprozess basiert darauf, dass sich die Ätzraten zumindest für die verwendeten unterschiedlichen III-V-Materialien des Solarzellenstapels nicht wesentlich unterscheiden. Eine Isolierung und Metallisierung der Vorderseite und des Lochs wird vor dem Dünnen der Substratschicht durchgeführt.

Wird die Isolationsschicht flächig beispielsweise auf die Vorderseite des Solarzellenstapels und die Seitenfläche der Durchgangskontaktöffnung aufgebracht, so muss die Isolationsschicht vor dem Aufbringen der Metallkontakte strukturiert werden, d.h. die Isolationsschicht lokal wieder entfernt werden.

Die Strukturierung der Isolationsschicht kann beispielsweise durch Aufbringen von Photolack mittels des Spin-Coating Verfahrens, photolithographischer Strukturierung des Photolacks und einem anschließenden nasschemischen Ätzschritt erfolgen. Bei diesem Schritt muss v.a. die Durchgangskontaktöffnung zuverlässig vor dem Ätzmedium geschützt werden.-

Eine weitere Möglichkeit ist es Oberflächen, insbesondere mit Löchern, mittels einer Folie zu beschichten. Solche Folien werden beispielsweise von der Firma DuPont als DuPont Dry Film Resists angeboten und vertrieben z.B. durch micro resist technology GmbH, Berlin.

Vor diesem Hintergrund besteht die Aufgabe der Erfindung darin, ein Verfahren zur Strukturierung einer Isolationsschicht auf einer Halbleiterscheibe anzugeben, die den Stand der Technik weiterbildet.

Die Aufgabe wird durch ein Verfahren mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Verfahren zur Strukturierung einer Isolationsschicht auf einer Halbleiterscheibe mit Durchgangsöffnungen bereitgestellt, mindestens umfassend die Schritte:
- Bereitstellen einer Halbleiterscheibe mit einer Oberseite, einer Unterseite und umfassend mehrere Solarzellenstapel, wobei jeder Solarzellenstapel ein die Unterseite der Halbleiterscheibe ausbildendes Ge-Substrat, eine Ge-Teilzelle und mindestens zwei III-V-Teilzellen in der genannten Reihenfolge sowie mindestens eine von der Oberseite bis zu der Unterseite der Halbleiterscheibe reichende Durchgangsöffnung mit zusammenhängender Seitenwand und einem im Querschnitt ovalen Umfang aufweist,
- Flächig aufzubringende Isolationsschicht auf der Oberseite der Halbleiterscheibe, der Seitenwand der Durchgangsöffnung und/oder der Unterseite der Halbleiterscheibe
- Strukturiertes Aufbringen eines ätzresistenten Füllmaterials mittels eines Druckverfahrens auf einen die Durchgangsöffnung umfassenden Bereich der Oberseite und in die Durchgangsöffnung hinein.

Es versteht sich, dass die Durchgangsöffnung vorzugsweise oval ausgebildet ist. Es sei angemerkt, dass vorliegend mit dem Begriff "oval" auch runde insbesondere kreisförmige, eiförmige und elliptische Formen umfasst sind. In einer anderen Ausführungsform ist die Durchgangsöffnung als viereckige Form mit abgerundeten Ecken ausgebildet.

Vorzugsweise wird vor der Ausbildung der Durchgangsöffnung die Halbleiterscheibe, die im allgemeinen einen Durchmesser von 100 mm oder 150 mm aufweist auf die gewünschte Enddicke gedünnt. Hierzu wird auf der Rückseite Ge-Material abgetragen. Es versteht sich das bei jedem Solarzellenstapel mittels einer oder mehrere Durchgangsöffnungen die Vorderseite von der Rückseite angeschlossen ist.

Es sei angemerkt, dass mit dem Begriff "Isolationsschicht" insbesondere auch ein die Isolationsschicht umfassendes dielektrisches Schichtsystem verstanden wird.

Des Weiteren sei angemerkt, dass die Halbleiterscheibe mit einem Ge-Substrat zumindest einen oder mehrere nicht vereinzelte Solarzellenstapel aufweist.

Ein Vorteil des Verfahrens besteht darin, dass mittels des strukturierten Aufbringens des organischen Füllmaterials kein photolithographischer Strukturierungsprozess für die Ausbildung der Durchkontaktierung benötigt und ein zuverlässiger Schutz der Isolationsschicht im Bereich der Durchgangsöffnung ausgebildet wird. Insbesondere wird das Aufbringen einer Lackschicht vermieden.

Anders ausgedrückt, die Durchgangsöffnung und die an die Durchgangsöffnung angrenzenden Bereiche werden auf der Oberseite und / oder auf der Unterseite ausschließlich mittels des Druckverfahrens gefüllt bzw. bedeckt.

Durch das strukturierte Aufbringen des im Vergleich zu der Isolationsschicht ätzresistenten Füllmaterials mittels des Druckverfahrens, z.B. mittels Inkjet, Siebdruck oder Dispensing, ist der zeitliche und technische Aufwand sowie der Materialverbrauch im Vergleich zum Stand der Technik gering. Ein weiterer Vorteil ist, dass die Zuverlässigkeit und die Ausbeute erhöht wird.

Mit dem Verfahren lassen sich auf einfache und kostengünstige Weise hocheffiziente und zuverlässige Mehrfach-Solarzellen herstellen, deren Vorderseite elektrisch an der Rückseite angeschlossen ist.

In einer Ausführungsform wird das ätzresistente Füllmaterial vor oder nach oder während des Aufbringens auf die Oberseite der Halbleiterscheibe zusätzlich auf einen die Durchgangsöffnung umfassenden Teil der Unterseite der Halbleiterscheibe und in die Durchgangsöffnung aufgebracht.

Es versteht sich, dass mit dem Begriff "ätzresistent" eine im Vergleich zu dem der Isolationsschicht geringere Ätzrate aufweist. Vorzugsweise beträgt die Selektivität wenigstens 1 zu 10 oder wenigstens 1 zu 100.

In einer Weiterbildung weisen bei der Durchgangsöffnung der Bereich mit ätzresistenten Füllmaterial an der Oberseite und der Teil mit ätzresistenten Füllmaterial an der Unterseite jeweils einen vollständig um die Durchgangsöffnung umlaufenden Randbereich auf.

In einer anderen Weiterbildung weist der jeweilige Randbereich parallel zur Halbleiterscheibe an der Oberseite und / oder an der Unterseite einen Durchmesser von wenigstens 50 µm und höchstens 3,0 mm auf.

In einer Ausführungsform weist der Randbereich parallel zur Halbleiterscheibe einen Durchmesser von wenigstens 100 µm und höchstens 1,0 mm auf. Vorzugsweise weist der Randbereich an der Oberseite einen anderen Durchmesser als an der Unterseite auf. Insbesondere weist der Randbereich an der Oberseite einen kleineren oder einen größeren oder einen gleichen Durchmesser als an der Unterseite auf.

In einer Weiterbildung wird die Isolationsschicht in den nicht mit dem Füllmaterial abgedeckten Bereichen mittels eines nasschemischen Ätzprozesses und / oder mittels eines RIE (Reactive Ionen Etching) Ätzprozesses entfernt.

In einer Weiterbildung wird in allen nicht mit dem Füllmaterial bedruckten Bereichen auf der Oberseite und / oder auf der Unterseite der Halbleitescheibe die Isolationsschicht entfernt.

In einer Ausführungsform wird mittels des Druckverfahrens die Durchgangsöffnung vollständig gefüllt. In einer anderen Ausführungsform wird von dem Füllmaterial eine über die Oberseite und eine über die Unterseite hinausragende Erhebung ausgebildet.

In einer anderen Ausführungsform wird für das Druckverfahren ein Inkjet-Verfahren oder ein Siebdruckverfahren oder ein Dispens-Verfahren verwendet. In einer Weiterbildung umfasst das Druckverfahren eine Kombination von unterschiedlichen Verfahren. Vorzugsweise umfasst das Druckverfahren ein Inkjet-Verfahren und / oder ein Siebdruckverfahren und / oder ein Dispens-Verfahren.

In einer anderen Weiterbildung umfasst das Füllmaterial ein Wachs und / oder ein Lack und / oder ein Harz und / oder ein Schmelzklebstoff und / oder ein Thermoplast.

In einer Ausführungsform weist die Durchgangsöffnung der Halbleiterscheibe eine Gesamtdicke von höchstens 500 µm und von mindestens 70 µm oder von höchstens 300 µm und von mindestens 80 µm auf.

In einer Weiterbildung wird das ätzresistente Füllmaterial ausschließlich in den die Durchgangsöffnungen umfassenden Bereichen auf die Halbleiterscheibe aufgebracht.

In einer Ausführungsform weisen die Bereiche für die Metallkontakte mindestens einen Durchmesser oder eine Kantenlänge von 50 µm und maximal 5 cm auf.

In einer anderen Ausführungsform weist die Durchgangsöffnung einen Durchmesser an der Oberseite zwischen 80 µm und 1 mm auf.

In einer Weiterbildung wird der Durchmesser der Durchgangsöffnung von der Oberseite in Richtung der Unterseite kleiner, wobei die Verjüngung vorzugsweise stufenmäßig ausgebildet ist.

In einer anderen Weiterbildung umfasst die Verjüngung genau eine in der Durchgangsöffnung oder genau zwei vollständig umlaufende Stufen. Vorzugsweise ist eine erste Stufe an der Grenzfläche zwischen Ge-Teilzelle und den aufliegenden III-V Teilzellen ausgebildet. Eine zweite Stufe ist vorzugsweise zwischen der Ge-Tellzelle und dem Ge-Substrat ausgebildet.

Vorzugsweise verjüngt sich die Durchgangsöffnung auch innerhalb des Ge-Substrats. Die stufenförmige bzw. konische Ausführung der Durchgangsöffnung hat den Vorteil, dass sich insbesondere bei einer vorzugsweise konformen Abscheidung der Isolationsschicht und / oder weiteren aufzubringenden Schichten im Rahmen einer Metallisierung die Dicke der Schichten sind auf den Seitenflächen hinreichend ausbilden lässt.

In einer Weiterbildung ist eine weitere Stufe an der Oberseite der Halbleiterscheibe an der Grenzfläche zwischen Metallstruktur und der Oberseite der obersten III-V Teilzelle ausgebildet.

In einer Ausführungsform wird oder ist ein Teil der Isolationsschicht auf einer Metallstruktur ausgebildet. Die Metallstruktur ist vorzugsweise oder ausschließlich an der Oberseite der Halbleiterscheibe ausgebildet.

Es sei angemerkt, dass die Metallstruktur insbesondere Fingerstrukturen zum Anschluss der Mehrfachsolarzelle an der Oberseite umfasst. In dem Bereich der Durchgangsöffnung umfasst die Metallstruktur vorzugsweise flächige Bereiche mit einer Größe von wenigstens 10 µm bis höchstens 1,5 mm.

In einer Weiterbildung umschließen die unterhalb der Isolationsschicht ausgebildeten flächigen Bereiche der Metallstruktur die Durchgangsöffnung vollständig. In einer Weiterbildung liegt die Dicke des Metalls der Metallstruktur In einem Bereich zwischen 2 µm und 30 µm.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckung sind nicht maßstäblich und weisen, sofern nicht anders angegeben, auch keine ableitbaren geometrischen Relationen zueinander auf. Darin zeigen, die
- Figur 1a, b, c: -jeweils im Querschnitt einen Ablauf mit Füllen einer Durchgangsöffnung mit einem nachfolgenden Ätzschritt,
- Figur 2: einen Querschnitt einer strukturierten Isolationsschicht mit freigelegter Durchgangsöffnung,
- Figur 3: eine Aufsicht auf eine Halbleiterscheibe mit einer Vielzahl von Solarzellenstapeln.

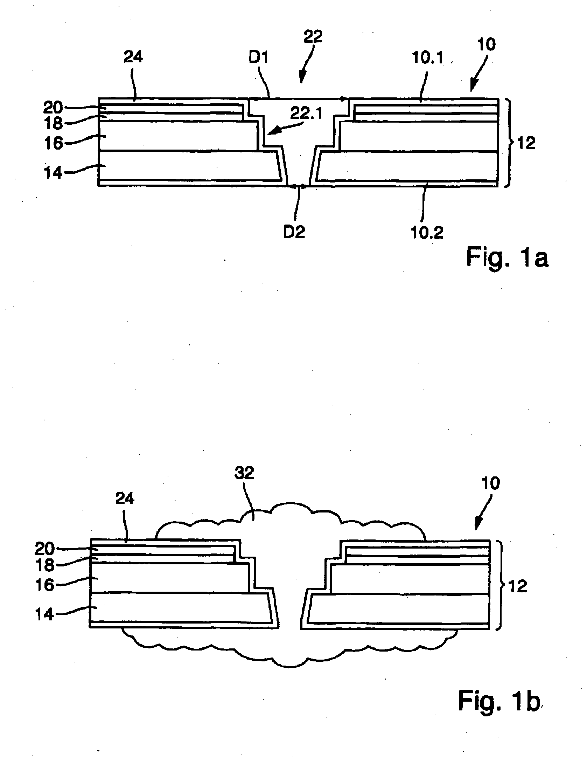

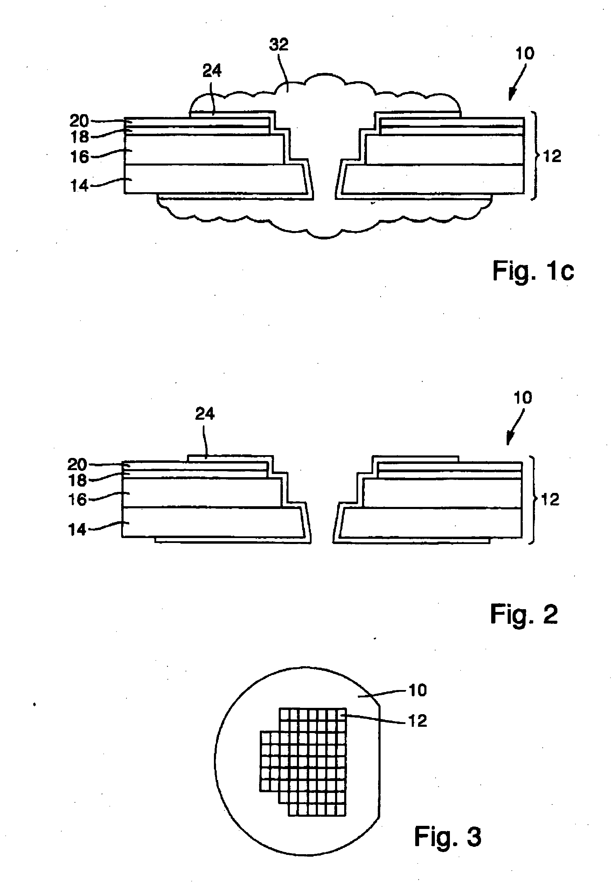

Die Abbildungen der Figur 1a, b und c zeigen einen Ablauf eines Verfahrens zur Strukturierung einer Isolationsschicht 24 auf einer Halbleiterscheibe 10 mit Füllen einer Durchgangsöffnung 22 mit anschließender Strukturierung einer Isolationsschicht 24 an einer Halbleiterscheibe 10.

Die Figur 1a zeigt einen Schnitt durch die nicht gefüllte Durchgangsöffnung 22 der Halbleiterscheibe 10. Die Halbleiterscheibe 10 weist eine Oberseite 10.1, eine Unterseite 10.2 und die sich von der Oberseite 10.1 bis zu der Unterseite 10.2 erstreckende Durchgangsöffnung 22 mit einer zusammenhängenden Seitenwand 22.1 auf.

Die Oberseite 10.1 und die Seitenwand 22.1 und die Unterseite 10.2 sind ganzflächig mit der Isolationsschicht 24 bedeckt, wobei die Isolationsschicht 24 die Oberflächen jeweils vollständig bedeckt. Es versteht sich, dass die Isolationsschicht 24 vorzugsweise als Schichtsystem mit mehreren Schichten ausgebildet ist.

Die Halbleiterscheibe 10 umfasst wenigstens einen im Allgemeinen jedoch mehrere noch nicht vereinzelte Solarzellenstapel 12 jeweils mit einer Schichtfolge aus einem die Unterseite 10.2 ausbildenden Ge-Substrat 14, einer Ge-Teilzelle 16, einer ersten III-V-Teilzelle 18 und einer die Oberseite 10.1 ausbildenden zweiten III-V-Teilzelle 20.

In einer nicht dargestellten Draufsicht weist die Durchgangsöffnung 22 einen nahezu kreisförmigen Querschnitt auf, wobei die dargestellten Schichten umlaufend, sowohl an der Oberseite 10.1 als auch in der Durchgangsöffnung 22 als auch auf der Unterseite 10.2 ausgebildet sind.

An der Oberseite 10.1 weist die Durchgangsöffnung 22 einen ersten Durchmesser D1 und an der Unterseite 10.2 einen zweiten Durchmesser D2 auf. Der erste Durchmesser D1 ist größer als der zweite Durchmesser D2. Die Verjüngung der Durchgangsöffnung 22 von der Oberseite 10.1 hinzu der Unterseite 10.2 erfolgt in mehreren vollständig umlaufenden Stufen. In dem vorliegenden Ausführungsbeispiel umfasst die Verjüngung genau zwei Stufen.

In einer nicht dargestellten Ausführungsform ist der erste Durchmesser D1 kleiner als der zweite Durchmesser D2.

Aus Richtung der Oberseite 10.1 gesehen, ist die erste Stufe an einer Grenzfläche zwischen der untersten III-V Teilzelle 18 und der Ge-Teilzelle 16 ausgebildet. Die zweite Stufe ist zwischen der Ge-Teilzelle 16 und dem Ge-Substrat 14 ausgebildet.

Vorzugsweise verjüngt sich die Durchgangsöffnung 22 auch innerhalb des Ge-Substrats 14. Die stufenförmige bzw. konische Ausführung der Durchgangsöffnung hat den Vorteil, dass sich insbesondere bei einer vorzugsweise konformen Abscheidung der Isolationsschicht 10 und / oder weiteren aufzubringenden Schichten im Rahmen einer Metallisierung die Dicke der Schichten auf den Seitenflächen hinreichend ausbilden lässt.

In einem weiteren Verfahrensschritt, dargestellt in der Abbildung der Figur 1b wird ein im Vergleich zu der Isolationsschicht ätzresistentes Füllmaterial 32 mittels eines Druckverfahrens auf einen die Durchgangsöffnung 22 umfassenden Bereich der Oberseite 10.1 der Durchgangsöffnung 22 aufgebracht

Das Füllmaterial füllt die Durchgangsöffnung 22 bis zur Oberseite 10.1 der Halbleiterscheibe nicht nur vollständig aus, sondern bildet auf der Oberseite 10.1 als auch auf der Unterseite 10.2 jeweils eine hinausragende Erhebung aus. Auf der Unterseite 10.2. überdeckt das Füllmaterial 32 einen größeren Randbereich als auf der Oberseite 10.1.

Mittels eines nachfolgenden Ätzschrittes wird die Isolationsschicht 24 in den nicht mit dem Füllmaterial 32 überdeckten Bereichen weggeätzt, wie im Ergebnis in der Abbildung 1c dargestellt.

In der Abbildung der Figur 2 ist der Querschnitt einer mittels des erfindungsgemäßen Verfahrens strukturierten Isolationsschicht auf einer Halbleiterscheibe mit Durchgangsöffnung dargestellt. Im Folgenden werden nur die Unterschiede zu den Abbildungen der Figur 1 erläutert.

In einem weiteren Verfahrensschritt Ist das Füllmaterial 32 vollständig entfernt.

In der Abbildung der Figur 3 ist eine Aufsicht auf eine Halbleiterscheibe 10 mit mehreren Solarzellenstapeln 12 dargestellt. Es versteht sich, dass sich in jedem Bereich jedes Solarzellenstapels mindestens ein Loch, welches mittels des Verfahrens bearbeitet wird, ausgebildet ist.

## Patentansprüche

1. Verfahren zur Strukturierung einer Isolationsschicht auf einer Halbleiterscheibe mit einer Durchgangsöffnung (22) auf einer Halbleiterscheibe (10) mindestens umfassend die Schritte:
- Bereitstellen einer Halbleiterscheibe (10) mit einer Oberseite (10.1), einer Unterseite (10.2) und umfassend mehrere Solarzellenstapel (12),
- wobei jeder Solarzellenstapel (12) ein die Unterseite (10.2) der Halbleiterscheibe ausbildendes Ge-Substrat (14), eine Ge-Teilzelle (16) und mindestens zwei III-V-Teilzellen (18, 20) in der genannten Reihenfolge sowie mindestens eine von der Oberseite (10.1) bis zu der Unterseite (10.2) der Halbleiterscheibe (10) reichende Durchgangsöffnung (22) mit zusammenhängender Seitenwand (22.1) aufweist,
- flächig aufgebrachte Isolationsschicht (24) auf der Oberseite (10.1) der Halbleiterscheibe (10), der Seitenwand (22.1) der Durchgangsöffnung (22) und/oder der Unterseite (10.2) der Halbleiterscheibe (10)
- Aufbringen eines ätzresistenten Füllmaterials (32) mittels eines Druckverfahrens auf einen die Durchgangsöffnung (22) umfassenden Bereich der Oberseite (10.1) und in die Durchgangsöffnung (22) hinein.

2. Verfahren nach Anspruch 1, **dadurch gekennzeichnet, dass** das ätzresistente Füllmaterial vor oder nach oder während des Aufbringens auf die Oberseite (10.1) der Halbleiterscheibe (10) zusätzlich auf einen die Durchgangsöffnung (22) umfassenden Teil der Unterseite (10.2) der Halbleiterscheibe (10) und in die Durchgangsöffnung (22) aufgebracht wird.

3. Verfahren nach Anspruch 1 oder Anspruch 2, **dadurch gekennzeichnet, dass** bei der Durchgangsöffnung (22) der Bereich an der Oberseite (10.1) und der Teil an der Unterseite (10.2) jeweils einen vollständig um die Durchgangsöffnung (22) umlaufenden Randbereich aufweisen oder jeweils als ein vollständig um die Durchgangsöffnung (22) umlaufender Randbereich ausgebildet ist und der jeweilige Randbereich parallel zur Halbleiterscheibe (10) einen Durchmesser von wenigstens 50 µm und höchstens 3,0 mm aufweist.

4. Verfahren nach Anspruch 3, **dadurch gekennzeichnet, dass** der Randbereich parallel zur Halbleiterscheibe (10) einen Durchmesser von wenigstens 100 µm und höchstens 1,0 mm aufweist.

5. Verfahren nach Anspruch 3 oder Anspruch 4, **dadurch gekennzeichnet, dass** der Randbereich an der Oberseite einen anderen, insbesondere kleineren Durchmesser als an der Unterseite aufweist.

6. Verfahren nach einem der vorstehenden Ansprüche, **dadurch gekennzeichnet, dass** mittels des Druckverfahrens die Durchgangsöffnung (22) vollständig gefüllt wird und von dem Füllmaterial (32) eine über die Oberseite (10.1) und eine über die Unterseite (10.2) hinausragende Erhebung ausgebildet.

7. Verfahren nach einem der vorstehenden Ansprüche, **dadurch gekennzeichnet, dass** das Druckverfahren ein Inkjet-Verfahren, ein Siebdruckverfahren oder ein Dispens-Verfahren ist.

8. Verfahren nach einem der vorstehenden Ansprüche, **dadurch gekennzeichnet, dass** das Füllmaterial (32) ein Wachs, ein Lack, ein Harz, ein Schmelzklebstoff oder ein Thermoplast ist.

9. Verfahren nach einem der vorstehenden Ansprüche, **dadurch gekennzeichnet, dass** die Durchgangsöffnung (22) der Halbleiterscheibe (10) eine Gesamtdicke (H1) von höchstens 500 µm und von mindestens 70 µm aufweist oder von höchstens 300 µm und von mindestens 80 µm aufweist.

10. Verfahren nach einem der vorstehenden Ansprüche, **dadurch gekennzeichnet, dass** die Durchgangsöffnung (22) der Halbleiterscheibe (10) einem im Querschnitt ovalen Umfang, insbesondere einen runden Umfang aufweist.

11. Verfahren nach einem der vorstehenden Ansprüche, **dadurch gekennzeichnet, dass** das ätzresistente Füllmaterial ausschließlich in die Durchgangsöffnungen (22) umfassenden Bereichen auf die Halbleiterscheibe (10) aufgebracht wird.

12. Verfahren nach Anspruch 11, **dadurch gekennzeichnet, dass** die Bereiche für die Metallkontakte mindestens einen Durchmesser oder eine Kantenlänge von 50 µm und maximal 5 cm aufweisen

13. Verfahren nach einem der vorstehenden Ansprüche, **dadurch gekennzeichnet, dass** die Durchgangsöffnung (22) einen Durchmesser zwischen 80 µm und 1 mm aufweisen.

14. Verfahren nach einem der vorstehenden Ansprüche, **dadurch gekennzeichnet, dass** der Durchmesser der Durchgangsöffnung (22) von der Oberseite (10.1) in Richtung der Unterseite (10.2) kleiner wird und die Verjüngung vorzugsweise stufenmäßig ausgebildet ist.

15. Verfahren nach einem der vorstehenden Ansprüche, **dadurch gekennzeichnet, dass** ein Teil der Isolationsschicht auf einer Metallfläche ausgebildet wird.
